# EUROPÄISCHE PATENTSCHRIFT

(11) **EP 1 524 744 B1**
(45) Veröffentlichungstag und Bekanntmachung des Hinweises auf die Patenterteilung: **14.11.2007**
(21) Anmeldenummer: 04021506.3
(22) Anmeldetag: 10.09.2004
(51) Int. Cl.: H02G 3/08, H02B 1/26

(54) **Verteiler zum Anschluss elektrischer Geräte mit Leuchteinrichtung**
Distributor for the connection of electrical devices with lighting assembly
Distributeur pour la connexion de dispositifs électriques avec dispositif d'éclairage

(30) Priorität: 15.10.2003 DE 20315838 U
(43) Veröffentlichungstag der Anmeldung: 20.04.2005
(73) Patentinhaber: Weidmüller Interface GmbH & Co. KG, 32760 Detmold (DE)
(72) Erfinder: Reker, Stefan, 33659 Bielefeld (DE); Hoffmann, Andreas, 32657 Lemgo (DE)
(74) Vertreter: Specht, Peter

(56) Entgegenhaltungen:
- EP-A- 1 258 957
- US-A- 4 000 447
- US-A- 5 716 241
- US-A- 6 028 865
- US-B1- 6 392 319

## Beschreibung

Die Erfindung betrifft einen Verteiler nach dem Oberbegriff des Anspruches 1..

Verteiler dieser Art in passiver oder aktiver Ausführung setzen sich im Bereich der Automatisierungstechnik immer mehr durch und ersetzen dort bisherige, aufwendigere Lösungen.

Einen gattungsgemäßen Verteiler zeigen die DE 299 19 900 oder die US 6,123,585.

Die US 6,392,319 zeigt ein Reihenklemmsystem der Automatisierungstechnik in Modulform zum Aufrasten auf Tragschienen, bei dem Busleiter als Lichtleiter ausgebildet sein können. Auch die EP 1 258 957 A1 und die US 5,716,241 zeigen jeweils Reihenklemmensysteme der Automatisierungstechnik in Modulform zum Aufrasten auf Tragschienen. Die US 4,000,447 zeigt ein Motoranschlußsystem mit einer Klarsichtklappe.

DE 28 37 209 A1 zeigt einen Schalter mit einer Leuchtkörperschicht, die von der Seite her beleuchtbar ist.

Die EP 0 797 341 zeigt eine Anlage mit einer Leuchtquelle.

Die US 6,028,865 zeigt ein Anschlußsystem für Hausinstallationen.

Wichtig ist, dass Verteiler nicht nur einen einfachen und schnellen Anschluss aller notwendigen Kabel sondern auch eine einfache und schnelle Einstellung aller notwendigen Parameter, insbesondere von Adressen ermöglichen. Dieses Einstellen erfolgt im allgemeinen mit Jumpern oder dgl..

Die Erfindung hat das Ziel, die Betätigung dieser Adressier- und/oder Umschalter im Vergleich zum Stand der Technik zu erleichtern.

Die Erfindung löst diese Aufgabe durch den Gegenstand des Anspruches 1.

Danach sind zumindest die Adressier- und/oder Umschalter (wenigstens einer oder alle) in einem beleuchteten Feld angeordnet.

Die Beleuchtung des umgebenden Feldes erleichtert einerseits das Auffinden der entsprechenden Schalter und andererseits auch deren Betätigung und hier insbesondere das Umstecken von Jumpern oder dgl.. Hervorzuheben ist auch die erhöhte Sicherheit, denn durch die Beleuchtung werden Fehleinstellungen auf einfachste Weise vermieden.

Vorteilhafte Ausgestaltungen sind den Unteransprüchen zu entnehmen. Hervorzuheben ist insbesondere als Option die einfache Realisierbarkeit als Klarsichtkappe über den Schaltern, die auch eine Lupenfunktion übernehmen kann.

Nachfolgend wird die Erfindung unter Bezug auf die Zeichnung anhand von Ausführungsbeispielen näher beschrieben. Es zeigt:

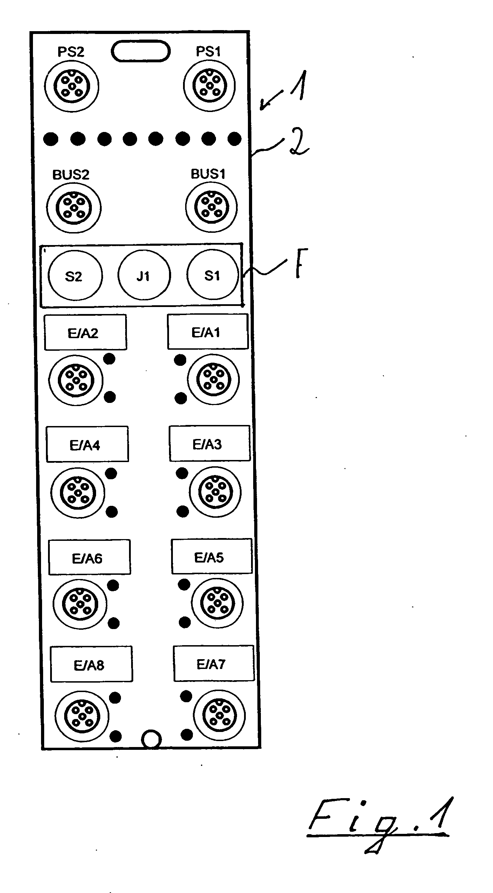

Fig. 1 ein Draufsicht auf eine schematische Darstellung eines Verteilers.

Fig. 1 zeigt einen Verteiler 1 zum Anschluss hier nicht dargestellter elektrischer Geräte wie Aktoren, Sensoren oder dgl., mit einem Gehäuse 2 sowie ersten Anschlüssen E/A1 bis E/A8 zum Anschluss der elektrischen Geräte und zweiten Anschlüssen BUS1 und BUS2 zum Anschluss eines übergeordneten Bussystems sowie hier zwei weiteren Anschlüssen PS 1 und PS2 zum Anschluss von Versorgungsleitungen.

Darüber hinaus weist das Gehäuse 1 auf seiner mit den Anschlüssen versehenen Oberseite mehrere - hier beispielhaft zwei - Adressierschalter S 1 und S2 sowie einen Umschalter J1 auf.

Mit den Adressierschaltern S1 und S2 können den ersten Anschlüssen Adressen zugewiesen werden wohingegen der Umschalter (Jumper J1) z.B. zum Umschalten zwischen den Anschlüssen für die Versorgungsleitungsanschlüsse PS1 und PS2 dient.

Die Adressier- und die Umschalter S1, S2, J1 sind in einem Feld F aus einem transparentem Material angeordnet, welches beispielsweise mittels Leuchtdioden oder dgl. direkt oder über zwischengeschaltete Lichtleiter beleuchtet wird, um das Auffinden, das Überprüfen der Einstellung und die Handhabung der Schalter S1, S2 und J1 zu erleichtern.

Das Feld ist in einen entsprechenden Ausschnitt des Gehäuses eingesetzt (hier nicht zu erkennen) und kann sich auch über weitere Bereiche des Gehäuses erstrecken und dazu dienen, auch Anschlüsse oder dgl. mit zu beleuchten.

Hinsichtlich der Handhabung ist noch als besonders vorteilhaft hervorzuheben, dass sämtliche Anschlüsse und Schalter auf einer gemeinsamen Seite des Gehäuses 1 - hier auf der Oberseite - angeordnet sind.

Hinsichtlich der Handhabung ist noch als besonders vorteilhaft hervorzuheben, dass sämtliche Anschlüsse und Schalter auf einer gemeinsamen Seite des Gehäuses 1 - hier auf der Oberseite - angeordnet sind.

## Patentansprüche

1. Verteiler zum Anschluss elektrischer Geräte, d.h. Aktoren, Sensoren oder dgl., mit
a) einem Gehäuse (1),
b) ersten Anschlüssen (E/A1 - E/A2) zum Anschluss der elektrischen Geräte,
c) wenigstens einem zweiten Anschluss (BUS1, BUS2) zum Anschluss eines übergeordneten Bussystems,
**dadurch gekennzeichnet, dass** der Verteiler außerdem
d) wenigstens einem oder mehreren Adressier- und/oder Umschaltern (S1, S2, J1) aufweist, und
e) zumindest die Adressier- und/oder Umschalter (S1, S2, J1) in einem beleuchteten Feld (F) angeordnet sind, das aus transparentem Material besteht.

2. Verteiler nach Anspruch 1, **dadurch gekennzeichnet, dass** das Feld (F) mittels einer Leuchtquelle, insbesondere Leuchtdioden direkt oder indirekt über Lichtleiter beleuchtet ist.

3. Verteiler nach Anspruch 2, **dadurch gekennzeichnet, dass** das Feld (F) als Klarsichtkappe ausgebildet ist.

4. Verteiler nach Anspruch 3, **dadurch gekennzeichnet, dass** die Klarsichtkappe eine Lupe ausbildet, welche den Bereich der Adressier- und/oder Umschalter (S1, S2, J1) vergrößert abbildet.

5. Verteiler nach einem der vorstehenden Ansprüche, **dadurch gekennzeichnet, dass** sämtliche Anschlüsse und Schalter auf einer gemeinsamen Seite des Gehäuses (1) angeordnet sind.

## Claims

1. Distributor for the connection of electrical devices, i.e. actuators, sensors or the like, with
a) a housing (1),
b) first connections (E/A1 - E/A2) for the connection of the electrical devices,
c) at least one second connection (BUS1, BUS2) for the connection of a higher-level bus system, **characterised in that** the distributor in addition
d) comprises one or more addressing and/or changeover switches (S1, S2, J1), and **in that**
e) at least the addressing and/or changeover switches (S1, S2, J1) are located in an illuminated panel (F) made of a transparent material.

2. Distributor according to claim 1, **characterised in that** the panel (F) is directly or indirectly illuminated via optical fibres by means of a light source, in particular light-emitting diodes.

3. Distributor according to claim 2, **characterised in that** the panel (F) is designed as a transparent cap.

4. Distributor according to claim 3, **characterised in that** the transparent cap forms a magnifying lens which provides an enlarged view of the area of the addressing and/or changeover switches (S1, S2, J1).

5. Distributor according to any of the preceding claims, **characterised in that** all of the connections and switches are located together on the same side of the housing (1).

## Revendications

1. Tableau de distribution destiné au raccordement d'appareils électriques, c'est-à-dire d'actionneurs, de capteurs ou similaires, comprenant
a) un boîtier (1),
b) des premières bornes (E/A1-E/A2) destinées au branchement des appareils électriques,
c) au moins une deuxième borne (BUS1, BUS2) destinée au branchement d'un système de bus prioritaire,
d) **caractérisé en ce que** le tableau de distribution présente, en outre, au moins un ou plusieurs commutateurs d'adressage et/ou inverseurs (S1, S2, J1), et **en ce que**
e) au moins les commutateurs d'adressage et/ou inverseurs (S1, S2, J1) sont disposés dans un champ éclairé (F) constitué en matériau transparent.

2. Tableau de distribution selon la revendication 1, **caractérisé en ce que** le champ (F) est éclairé par une source lumineuse, en particulier par des diodes luminescentes, directement ou indirectement par le biais de conducteurs de lumière.

3. Tableau de distribution selon la revendication 2, **caractérisé en ce que** le champ (F) est conformé en capuchon transparent.

4. Tableau de distribution selon la revendication 3, **caractérisé en ce que** le capuchon transparent constitue une loupe qui grossit la zone des commutateurs d'adressage et/ou inverseurs (S1, S2, J1).

5. Tableau de distribution selon l'une des revendications précédentes, **caractérisé en ce que** toutes les bornes et tous les commutateurs sont placés sur une face commune du boîtier (1).
